Europäisches Patentamt

European Patent Office

Office européen des brevets

(19)

(11)  **EP 1 619 510 A2**

(12)  **EUROPÄISCHE PATENTANMELDUNG**

(43) Veröffentlichungstag:
  **25.01.2006  Patentblatt 2006/04**

(51) Int Cl.:
  *G01R 31/00* *(2006.01)*      *G01R 31/04* *(2006.01)*
  *G01R 31/40* *(2006.01)*

(21) Anmeldenummer: **05104436.0**

(22) Anmeldetag: **25.05.2005**

(84) Benannte Vertragsstaaten:
  **AT BE BG CH CY CZ DE DK EE ES FI FR GB GR
  HU IE IS IT LI LT LU MC NL PL PT RO SE SI SK TR**
  Benannte Erstreckungsstaaten:
  **AL BA HR LV MK YU**

(30) Priorität: **22.07.2004  DE 102004035513**

(71) Anmelder: **ROBERT BOSCH GMBH
  70442 Stuttgart (DE)**

(72) Erfinder: **Merkle, Michael
  70192, Stuttgart (DE)**

(54)  **Verfahren zur Detektion der Verbindung zwischen Energiespeicher und dem Bordnetz eines Fahrzeugs**

(57)    Die Erfindung bezieht sich auf ein Verfahren zur Erkennung der elektrischen Verbindung eines Energiespeichers (1) mit einem Bordnetz (3), bei dem Betriebsgrößen Batteriestrom $I_B$, Generatorstrom $I_G$ im Wesentlichen zeitsynchron ermittelt werden. Bei einer Änderung des Generatorstroms $I_G$ des Generators (2) während einer Übergangszeit (9) wird der mindestens eine Energiespeicher (1) auf den Wert des Batteriestroms $I_B$ zur Detektion eines kompensierenden Effekts in Form einer Stromabgabe oder einer Stromaufnahme untersucht.

Fig. 2

EP 1 619 510 A2

**Beschreibung**

Technisches Gebiet

Zur Sicherstellung der Verfügbarkeit elektrischer Verbraucher in Bordnetzen von Kraftfahrzeugen insbesondere bei sicherheitskritischen Anwendungen in Kraftfahrzeugen, werden die Energiespeicher zur Versorgung dieser Systeme kontinuierlich hinsichtlich ihrer Leistungsfähigkeit und/oder verfügbaren Ladung bzw. Energie sowie ihrem Alterungs- bzw. Gesundheitszustand (!) überwacht. Grundvoraussetzung für die Bereitstellung elektrischer Energie durch Energiespeicher ist eine qualitativ hochwertige galvanische Verbindung zu Kabelbaum und Karosserie des Fahrzeugs.

Stand der Technik

Insbesondere ein vollständiger Verlust des Energiespeichers wie z.B. einer Fahrzeugbatterie im Fahrzeug ist unter Sicherheitsaspekten im Fahrbetrieb festzustellen und im Allgemeinen im Rahmen einer Warnmeldung anzuzeigen. Ein Verlust des Energiespeichers in Gestalt einer Kraftfahrzeugbatterie kann mehrere Gründe haben. So z.B. kann ein Bruch der leitenden Verbindung zwischen Minuspol und Karosserie aufgetreten sein, ferner ein Bruch am Polschuh oder am Zellenverbinder in der Batterie oder es kann ein Abfallen der Pollemme vom Batteriepol oder ein Kabelbruch der Verbindung ausgehend von der positiven Klemme aufgetreten sein, wodurch das dem Energiespeicher innewohnende Energiepotential nicht mehr genutzt werden kann.

Bei aus dem Stand der Technik bekannten Verfahren des Überwachens eines Energiespeichers wie beispielsweise einer Kraftfahrzeugbatterie wird die Messung der Batterieklemmenspannung, des Stroms sowie die Batterietemperatur unter Einsatz von induktiven oder ohmschen Batteriesensoren durchgeführt.

Gemäß eines aus DE 101 42 085 A1 bekannten Verfahrens wird eine Bordnetzdiagnose eines Kraftfahrzeugbordnetzes durchgeführt, wobei die Bordnetzspannung erfasst und deren Welligkeitsverlauf ausgewertet wird. Aus WO 98 205 94 ist ein Verfahren bekannt, mit welchem eine Unterbrechung der Verbindung zwischen Energiespeicher und Fahrzeugbordnetz erkannt wird. Gemäß WO 98 205 94 wird die Impedanz des Bordnetzes bewertet und aus dem Blickwinkel der Batterieklemmen betrachtet.

Beide Verfahren setzen die häufige Messung von Größen wie der Klemmenspannung und des Klemmenstroms des Energiespeichers voraus und erfordern eine Berechnung des Quotienten aus absoluten und/oder differentiellen Spannungs- bzw. Stromwerten. Aufgrund dieses Umstands erfordern die geschilderten Verfahren bedingt durch eine hohe Abtastrate eine relativ hohe Rechenkapazität. Gemäß der aus WO 98 205 94 bekannten Lösung wird die Impedanz des gesamten Bordnetzes eines Fahrzeugs aus Sicht des Energiespeichers, d.h. der Kfz-Batterie bestimmt. Ein Anstieg der Impedanz im Bordnetz des Kraftfahrzeugs über einen Schwellwert wird als ein Index für eine Unterbrechung der elektrischenVerbindung zwischen dem Energiespeicher und dem Kraftfahrzeug angesehen.

Aus DE 101 50 381 A1 ist ein Verfahren und eine Vorrichtung zur Verbesserung der Ausfallsicherheit von Fahrzeug-Bordnetzen bekannt. Das Fahrzeug-Bordnetz wird von wenigstens einer Batterie und einem Generator gespeist. Um die Stabilität des Bordnetzes zu gewährleisten, werden die Energiequellen ständig überwacht, und bei einem Defekt bzw. einer stark verminderten Leistungsfähigkeit einer der Energiequellen wird aktiv auf den Fahrbetrieb des Fahrzeugs eingegriffen, um den vollständigen Ausfall des betroffenen Systems während der Fahrt zu vermeiden. Dazu wird z.B. die maximale Drehzahl einer Verbrennungskraftmaschine eines Fahrzeugs begrenzt oder das Fahrzeug insbesondere bis zum vollständigen Stillstand abgebremst.

Aus DE 199 64 057 A1 ist ein Verfahren zur Erkennung einer defekten Kraftfahrzeugbatterie bekannt geworden. Bei laufendem Motor des Fahrzeugs wird die Batterie von einem Generator auf einen von einem Steuergerät vorgegebenen erhöhten Spannungssollwert aufgeladen und anschließend von einer elektrischen Last entladen. Die Spannungsdifferenz, die sich beim Auf- bzw. Entladen innerhalb eines Zeitintervalls ergibt, bzw. das Zeitintervall, das bis zum Erreichen von zwei Spannungsschwellwerten abläuft, wird als Indikator für den Betriebszustand der Batterie bzw. ihrer Speicherfähigkeit ausgewertet. Die Auswertung erfolgt am einfachsten durch Erfassung des Spannungsgradienten einer vorgegeben Kurve, die zuvor auf empirischem Wege ermittelt wurde. Das erhaltene Ergebnis wird auf einer entsprechenden Anzeige optisch oder akustisch ausgegeben.

DE 102 19 824 A1 bezieht sich auf ein Verfahren und eine Vorrichtung zur Erkennung eines batterielosen Betriebs eines Fahrzeugbordnetzes mit wenigstens einem von einem Motor angetriebenen Generator, einer Batterie sowie mit der Batterie verbindbaren Verbraucher sowie Mittel zu Spannungsauswertung. Mit der aus DE 192 19 824 A1 bekannten Vorrichtung werden die Generatorspannung sowie die Batteriespannung gemessen. Die ermittelten Spannungswerte werden zueinander in Bezug gesetzt und aus den daraus erhaltenen Ergebnissen wird auf eine Fehlfunktion der Batterie oder eine Unterbrechung zwischen der Batterie und dem Bordnetz und somit auf einen batterielosen Betrieb geschlossen. Es werden sowohl die Welligkeit der Generatorspannung als auch die Welligkeit der Bordnetzspannung ermittelt und die beiden ermittelten Welligkeiten zueinander in Bezug gesetzt. Bei Abweichung der ermittelten Welligkeit von vorgebbaren Grenzwerten wird ebenfalls auf einen batterielosen Betrieb erkannt. Eine Vorrichtung zur Durchführung des aus DE 102 19 824 A1 bekannten Verfahrens umfasst Mittel zur Spannungsauswertung so wenigstens einen Bandpass und/oder Mittel zur momentanen Scheitelwertmessung und/oder zur Maximal- und Minimalwertbestimmung von Spannungen, wobei die Mittel zur Spannungsmessung sowohl die Generatorspannung als auch die Batteriespannung messen.

## Darstellung der Erfindung

Dem erfindungsgemäß vorgeschlagenen Verfahren folgend, wird im Fahrbetrieb eines ein elektrisches Bordnetz aufweisenden Fahrzeugs eine schnelle und zuverlässige Erkennung, ob der Energiespeicher in Form einer Fahrzeugbatterie eine gute galvanische Verbindung mit Karosserie bzw. mit Kabelbaum besitzt, gewährleistet. Ferner kann dem erfindungsgemäß vorgeschlagenen Verfahren folgend ermittelt werden, ob innerhalb des Energiespeichers ein plötzlicher Defekt wie z.B. der Bruch eines Polschuhs oder dergleichen aufgetreten ist und dadurch die Funktion des Energiespeichers entscheidend beeinträchtigt wird.

Dem erfindungsgemäß vorgeschlagenen Verfahren folgend, wird ferner eine Information generiert, die als wesentliche Sicherheitsvoraussetzung für den Betrieb eines Bordnetzes und damit zur Sicherstellung von sicherheitskritischen Applikationen innerhalb eines elektrischen Fahrzeugbordnetzes geeignet ist.

Während bei den aus dem Stand der Technik bekannten Verfahren die Ermittlung des Innenwiderstands des Bordnetzes im Vordergrund steht, wird gemäß des vorgeschlagenen Verfahrens eine genaue und eindeutige Bestimmung dahingehend durchgeführt, ob eine galvanische Verbindung zwischen Bordnetz und Energiespeicher in Gestalt einer Fahrzeugbatterie besteht oder nicht. Es lässt sich darüber hinaus eine starke Reduzierung der notwendigen Rechenresourcen im Vergleich zur Ermittlung eines Innenwiderstands eines Energiespeichers erreichen. Ferner wird auf eine Spannungsmessung verzichtet, so dass der mit dieser einhergehende apparative Aufwand vermieden werden kann. Es lassen sich auch mehrere Energiespeicher, die in das elektrische Bordnetz eines Fahrzeugs eingebunden sind, überwachen sowie ausgefallene Energiespeicher selektiv identifizieren ebenso wie plötzlich auftretende Fehler in der Kontaktierung. Da das vorgeschlagene Verfahren nicht auf der Bestimmung des Innenwiderstands eines bestimmten Energiespeichers, z.B. einer Bleisäurebatterie basiert, kann dieses auch für verschiedenartige Energiespeicher so z.B. für Kondensatoren oder Doppelschichtkondensatoren eingesetzt werden.

Durch das erfindungsgemäß vorgeschlagene Verfahren ist kein aktiver Eingriff in das elektrische Bordnetz mittels des elektrischen Energiemanagements notwendig, so dass z.B. das Zu- und Abschalten von Verbrauchern entfallen kann.

## Zeichnung

Anhand der Zeichnungen wird die Erfindung nachstehend eingehender beschrieben.

Es zeigt:

Figur 1    die Struktur des Bordnetzes eines Kraftfahrzeugs und

Figur 2    einen exemplarisch herausgegriffenen Verlauf von Größen wie Generatorstrom, Verbraucherstrom und Batteriestrom während eines Ausgleichsvorgangs.

## Ausführungsvarianten

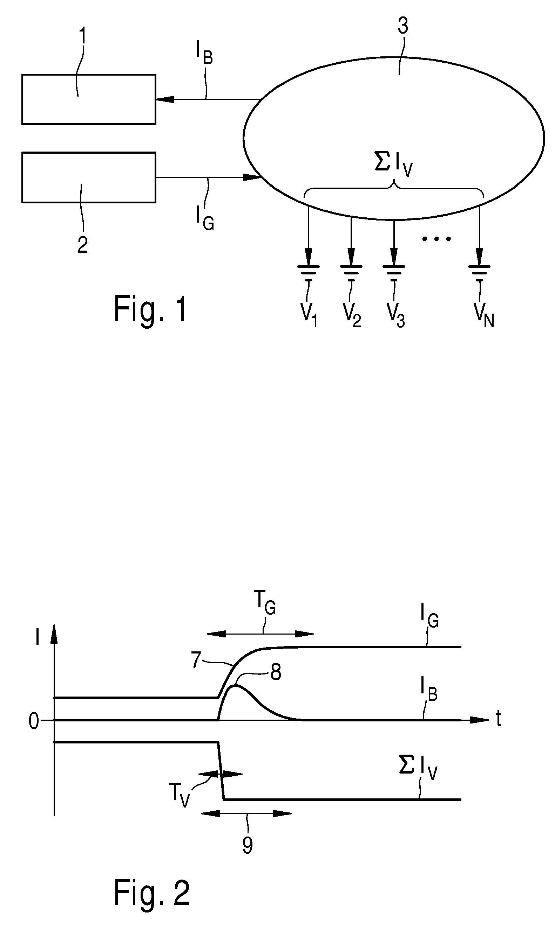

Der Darstellung gemäß Figur 1 ist die Struktur des elektrischen Bordnetzes eines Fahrzeugs zu entnehmen.

Ein elektrisches Bordnetz eines Kraftfahrzeugs z.B. umfasst einen Energiespeicher 1, der im Allgemeinen durch die Fahrzeugbatterie dargestellt wird. Nachstehend werden unter dem Begriff Energiespeicher auch von einer Fahrzeugbatterie verschiedene Energiespeicher wie z.B. Kondensatoren oder Doppelschichtkondensatoren verstanden.

Das in Figur 1 in schematischer Weise wiedergegebene Bordnetz 3 eines Kraftfahrzeugs umfasst neben Verbrauchern $V_1$, $V_2$, $V_3$.....bis $V_n$ einen Energiespeicher 1, der z.B. durch die Kfz-Batterie dargestellt wird. Zur Speisung des Bordnetzes 3 ist darüber hinaus ein von der in Figur 1 nicht dargestellten Verbrennungskraftmaschine angetriebener Generator 2 vorgesehen, bei dem es sich bei heute üblichen Ausführungsvarianten in der Regel um einen Drehstromgenerator handelt. Der Energiespeicher 1 wird im Allgemeinen durch eine Blei-Säure-Kfz-Batterie dargestellt; dem Generator 2 ist im Allgemeinen ein Generatorregler zugeordnet. Durch $V_n$ ist angedeutet, dass das Bordnetz 3 eines Kraftfahrzeugs eine unbestimmte Anzahl elektrischer Verbraucher umfassen kann.

Nachfolgend wird davon ausgegangen, dass für eine "Energiespeicher-ab"-Erkennung die nachfolgend ausgeführten Messwerte regelmäßig und in einem Abstand von mehreren 10 ms annähernd zeitsynchron ermittelt und vorliegen.

1. Batteriestrom $I_B$ des zu beobachtenden Energiespeichers 1

2. Generatorstrom $I_G$ oder eine andere Messgröße, die mit dem Generatorstrom $I_G$ korreliert.

Der Batteriestrom $I_B$ wird im Allgemeinen über einen Batteriesensor einer Recheneinheit über ein Bussystem bereitgestellt oder direkt auf dem Batteriesensor zur Ermittlung Batteriediagnose-relevanter Größen verarbeitet.

Es ist jedoch bei zukünftigen Anwendungen auch vorgesehen, dass über einen Informationsbus sowohl die Daten des Batteriesensors sowie z.B. der Batteriestrom $I_B$ als auch die Daten des Generators, d.h. dem Generatorstrom $I_G$ zu einer gemeinsamen Recheneinheit übertragen werden können.

Ergänzend sei angemerkt, dass mit $\Sigma\, I_v$ in der Darstellung gemäß Figur 1 die Summe aller Verbraucherströme im Bordnetz 3 des Kraftfahrzeugs bezeichnet ist. Die Anwendung des Kirchhoffschen Gesetzes führt auf folgende Gesetzmäßigkeit:

$$I_G = I_B + \Sigma\, I_V$$

Ist der Energiespeicher 1 ohne galvanischen Kontakt zur Fahrzeugkarosserie, führt dies zwingend auf:

$$I_B = 0$$

Ein innerhalb eines Bordnetzes 3 vorgesehener Batteriesensor gibt idealerweise den Strom $I_B = 0$ aus; üblicherweise ist jedoch das Ausgangssignal ein mittelwertfreies Rauschen. Die Bedingung lässt sich durch das Einhalten einer Toleranzschwelle um den Wert 0 herum überprüfen. Die Bedingung $I_B = 0$ alleine stellt jedoch keine hinreichende Bedingung für eine "Energiespeicher-ab"-Erkennung dar, da durchaus ein stationärer Zustand auftreten kann, in dem die Summe der Verbraucherleistungen exakt durch die Leistung des Generators 2 gedeckt ist, d.h. $I_G = \Sigma\, I_V$. In diesem stationären eingeschwungenen Zustand gilt ebenfalls $I_B = 0$.

Um eine Erkennung zu erreichen, ob der Energiespeicher 2 vom Bordnetz 3 getrennt ist, wird vorausgesetzt, dass die Verbraucherleistung nicht über einen längeren Zeitraum konstant ist. Die Änderung der elektrischen Verbraucherleistung erfolgt im Fahrbetrieb kontinuierlich durch Schaltvorgänge im Bordnetz, z.B. Aufleuchten der Bremsleuchten bei Bremsvorgängen, Betätigung elektrischer Fensterheber, Betätigung des Fahrtrichtungsanzeigers etc. Daneben sorgt die unregelmäßige Betätigung elektrischer Antriebe oder elektronischer Verbraucher (Zündung) für eine stetige Änderung der elektrischen Verbraucherleistung innerhalb des Bordnetzes 3 des Kraftfahrzeugs. Die beschriebene Änderung der benötigten elektrischen Verbraucherleistung $\Delta\, P_v$ führt demzufolge zu einer Änderung der benötigten Verbraucherleistung $\Delta\, P_v$ bei angenähert konstantem Spannungsniveau innerhalb des Bordnetzes 3 zu Stromänderungen $\Delta\, (\Sigma I_V)$.

Die Folgen einer derartigen Verbraucherstromänderung sind in Figur 2 dargestellt, der ein exemplarischer Verlauf der Größen Generatorstrom $I_G$, Verbraucherstrom $\Sigma\, I_v$ sowie Batteriestrom $I_B$ während eines Ausgleichsvorgangs entnehmbar ist. Die Kompensation der Änderung der Verbraucherleistung um $\Delta\, P_v$ erfolgt idealerweise durch eine schnelle Anpassung der Generatorleistung, um den neuen, innerhalb des Bordnetzes 3 erforderlichen Bedarf zu decken. Es wird unterstellt, dass eine Änderung der Generatorleistung am Generator 2 mit einer Zeitkonstante erfolgt, die durch die Trägheit der elektrischen Maschine (d.h. des Drehstromgenerators) und dem dieser zugeordneten Regler vorgegeben ist. Die Zeitkonstante $T_G$ liegt angenommenerweise in der Größenordnung zwischen 200 bis 400 ms. Der Darstellung gemäß Figur 2 ist entnehmbar, dass unmittelbar an eine durch die Zeitkonstante $T_v$ kenntlich gemachte Verbrauchsänderung (Verbraucherdynamik) im Bordnetz 3 beispielsweise mit der Zeitkonstanten $T_v = 10$ ms, die im Generator 2 erzeugte elektrische Leistung nicht sofort der verbrauchten elektrischen Leistung entspricht. Während des durch Bezugszeichen 9 angedeuteten Ausgleichsvorgangs wird die Leistungsdifferenz im Bordnetz 3 durch einen Energiespeicher, wie z.B. Fahrzeugbatterie 1 ausgeglichen.

Daraus ergibt sich, dass eine Änderung des Generatorstroms $I_G$, um eine Änderung des Verbrauchs im Bordnetz 3 zu decken, oder aufgrund der Vorgabe einer übergeordneten Regelung wie z.B. des elektrischen Energiemanagements im Bordnetz 3 immer innerhalb der mit der Zeitkonstante des Generators 2 sowie des diesem zugeordneten Generatorreglers verknüpften Übergangszeit dazu führt, dass die Energiespeicher 2 während dieser Übergangszeit, d.h. während der Zeitdauer des Ausgleichsvorgangs 9 einen kompensierenden Effekt in Form einer Stromabgabe oder eine Stromaufnahme zeigen, d.h. in dieser Übergangszeit gilt:

$$I_B \neq 0.$$

Für den Fall, dass $I_B = 0$ vorliegt, wird daher folgendermaßen verfahren, um zwischen dem Zustand "Energiespeicher-ab" und dem Zustand "Energiespeicher-an", wobei aber $I_G = \Sigma\, I_V$ gilt zu unterscheiden.

Es wird zunächst abgeprüft, ob eine erste Voraussetzung $I_B = 0$ innerhalb eines Toleranzbands erfüllt ist oder nicht.

Eine zweite Voraussetzung, d.h. ist dadurch gegeben, dass eine Änderung des Generatorstroms $I_G$ um mehr als x Ampere innerhalb von y ms vorliegt, wobei beispielsweise x = 10 und y = 50 betragen kann. In diesem Falle erfolgt eine Analyse des Batteriestroms $I_B$ innerhalb der Übergangsphase bezüglich der kompensierenden Wirkung, d.h. einer Stromaufnahme oder eine Stromabgabe des Energiespeichers 1.

Ist eine kompensierende Wirkung vorhanden, so wird darauf erkannt, dass der Energiespeicher 2 zur Verfügung steht, d.h. mit dem Bordnetz 3 des Fahrzeugs verbunden ist. Wird festgestellt, dass der Strom bei 0 innerhalb der Toleranzschwelle verbleibt, so zeigt der Energiespeicher 1 keinerlei kompensierende Wirkung, d.h. der Energiespeicher 2 ist demnach nicht mehr mit dem Bordnetz 3 des Fahrzeugs verbunden.

Eine Änderung des Generatorstroms $I_G$ kann nicht nur zwingend durch eine Verbrauchsänderung innerhalb des Bordnetzes 3 des Fahrzeugs getrieben sein, sondern kann auch infolge der bereits erwähnten übergeordneten Regelung durch ein Energiemanagementsystem erzwungen werden. Die kompensierende Wirkung der Energiespeicher 2 in der Übergangsphase, d.h. während des Ausgleichsvorgangs 9, ist bei einem intaktem Bordnetz 3 auch für diesen Fall beobachtbar. Die Kenntnis über die Summe der Verbraucherströme, d.h. $\Sigma\, I_V$ ist bei diesem Verfahren nicht erforderlich.

Zu den in den Figuren 1 und 2 dargestellten, innerhalb des Bordnetzes 3 aufgeführten Betriebsgrößen sei gesagt, dass der Batteriestrom $I_B$ Werte < 0 beim Entladen der Batterie annimmt; der Wert des Generatorstroms $I_G$ ist > 0 bei Abgabe von elektrischer Leistung ins Bordnetz 3 des Fahrzeugs. Der Verbraucherstrom $I_V$ eines individuellen Verbrauchers $V_1$, $V_2$, $V_3$ .....$V_N$ ist > 0 bei Entnahme elektrischer Leistung aus dem Bordnetz 3. Aus der Gegenüberstellung der zeitlichen Dauer der Zeit $T_V$ in der Zeitkonstanten $T_G$ des Generators 2 und seines Reglers wird deutlich, dass der Generator 2 deutlich träger ist als die im Bordnetz auftretenden Stromsprünge beim Zu- bzw. Abschalten von Verbrauchern. Diese sind umso stärker ausgeprägt, je größer die elektrischen Lasten sind, die innerhalb des Bordnetzes 3 im Betrieb des Kraftfahrzeugs zu- bzw. abgeschaltet werden, zum Beispiel das Zu- bzw. Abschalten einer Heckscheibenheizung.

Für den Fall, dass $I_G = \Sigma\, I_V$ gilt, ist eine Fallunterscheidung zur Erkennung des Zustands Batterie-ab und Batterie-liegt-an, zu treffen. Die erste Voraussetzung $I_B = 0$ ist stets für sich alleine zu erfüllen und stellt eine notwendige Bedingung für den Zustand Energiespeicher-ab dar. Wenn $I_B = 0$ ist, kann die Fahrzeugbatterie vom Bordnetz abgetrennt sein, muss es aber nicht. So kann z.B. im stationären Zustand auch $I_B = 0$ auftreten. Dies bedeutet, dass in diesem Fall der Ausgleichsvorgang zusätzlich ausgewertet wird, aber nur, falls die erste Voraussetzung greift, d.h. $I_B = 0$ ist.

Bezugszeichenliste

1   Energiespeicher (Kfz-Batterie)
2   Generator
3   Bordnetz
$V_1$   1. Verbraucher
$V_2$   2. Verbraucher
$V_3$   3.Verbraucher
$V_N$   n-ter Verbraucher
$I_B$   Batteriestrom
$I_G$   Generatorstrom
$I_V$   Verbraucherstrom eines individuellen Verbrauchers $V_1$, $V_2$, $V_3$
$\Sigma\, I_V$   Summe Verbraucherströme $I_V$
$T_G$   Generatorreglerdynamik (Zeitkonstante Generatorregler)
$T_V$   Verbraucherdynamik (Schaltvorgänge im Bordnetz 3)

7   Anstiegsflanke Generatorstrom $I_G$
8   Maximum Batteriestrom $I_B$
9   Ausgleichsvorgang

**Patentansprüche**

1.  Verfahren zur Erkennung der elektrischen Verbindung eines Energiespeichers (1) mit einem Bordnetz (3), bei dem Betriebsgrößen Batteriestrom $I_B$, Generatorstrom $I_G$ in etwa zeitsynchron erfasst werden, **dadurch gekennzeichnet, dass** bei einer Änderung des Generatorstroms $I_G$ des Generators (2) während einer Übergangszeit (9) der mindestens eine Energiespeicher (1) auf den Wert des Batteriestroms $I_B$ zur Detektion eines kompensierenden Effekts in Form einer Stromabgabe oder einer Stromaufnahme untersucht wird.

2.  Verfahren gemäß Anspruch 1, **dadurch gekennzeichnet, dass** die Übergangszeit (9) einer Zeitkonstanten $T_G$ des Generators und seines Reglers (2) entspricht.

3.  Verfahren gemäß Anspruch 1, **dadurch gekennzeichnet, dass** bei einem ermittelten Wert 0 für den Batteriestrom $I_B$ dieser auf seine Lage innerhalb eines Toleranzbands untersucht wird.

4.  Verfahren gemäß Anspruch 1, **dadurch gekennzeichnet, dass** bei einer Änderung des Generatorstroms $I_G$ um x Ampere während einer Zeitspanne von y ms eine Analyse des Batteriestroms $I_B$ innerhalb der Übergangszeit (9) erfolgt.

5.  Verfahren gemäß Anspruch 4, **dadurch gekennzeichnet, dass** bei Detektion einer kompensierenden Wirkung des Energiespeichers (2) auf einen mit dem Bordnetz (3) elektrisch verbundenen Energiespeicher (1) geschlossen wird.

6.  Verfahren gemäß Anspruch 4, **dadurch gekennzeichnet, dass** bei einem ermittelten Wert 0 für den Batteriestrom $I_B$ innerhalb eines Toleranzbandes auf einen elektrisch vom Bordnetz (3) getrennten Energiespeicher (1) geschlossen wird.

7.  Verfahren gemäß Anspruch 4, **dadurch gekennzeichnet, dass** 5 < x < 150 und der Wert für y < $T_G$ gewählt wird.

8.  Verfahren gemäß Anspruch 4, **dadurch gekennzeichnet, dass** bei einer Änderung des Generatorstroms ($I_G$) aufgrund von Zu- und Abschaltung elektrischer Verbraucher $V_I$, $V_2$, $V_3$.... $V_N$ innerhalb des Bordnetzes (3) erfolgt oder durch eine übergeordnete Regelung aufgeprägt wird.

**9.** Verfahren gemäß Anspruch 1, **dadurch gekennzeichnet, dass** die Werte für den Batteriestrom $I_B$ und den Generatorstrom $I_G$ zyklisch in einem zeitlichen Abstand von mehreren 10 ms erfasst werden.

Fig. 1

Fig. 2